(19) Europäisches Patentamt
European Patent Office
Office européen des brevets

(11) **EP 3 910 350 B1**

(12) **EUROPÄISCHE PATENTSCHRIFT**

(45) Veröffentlichungstag und Bekanntmachung des Hinweises auf die Patenterteilung:
**04.09.2024 Patentblatt 2024/36**

(21) Anmeldenummer: **21171485.2**

(22) Anmeldetag: **30.04.2021**

(51) Internationale Patentklassifikation (IPC):
**G01R 29/16** *(2006.01)*

(52) Gemeinsame Patentklassifikation (CPC):
**G01R 29/16**

(54) **VERFAHREN UND SCHALTUNGSANORDNUNG ZUM DETEKTIEREN EINER ASYMMETRIE ODER SYMMETRIE EINES MEHRPHASENSTROMNETZES**

METHOD AND CIRCUIT ASSEMBLY FOR DETECTING ASYMMETRY OR SYMMETRY OF A MULTIPHASE POWER NETWORK

PROCÉDÉ ET ENSEMBLE DE CIRCUITS PERMETTANT DE DÉTECTER UNE ASYMÉTRIE OU UNE SYMÉTRIE D'UN RÉSEAU ÉLECTRIQUE MULTIPHASÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.04.2020 DE 102020111893**

(43) Veröffentlichungstag der Anmeldung:
**17.11.2021 Patentblatt 2021/46**

(73) Patentinhaber: **EPA GmbH**
**63486 Bruchköbel (DE)**

(72) Erfinder: **DIENERSBERGER, Wolfgang**
**81925 München (DE)**

(74) Vertreter: **Stoffregen, Hans-Herbert**
**Patentanwalt**
**Friedrich-Ebert-Anlage 11b**
**63450 Hanau (DE)**

(56) Entgegenhaltungen:
**DE-A1- 19 509 658     US-A1- 2014 233 142**

**Beschreibung**

Die Erfindung betrifft ein Verfahren zum Detektieren einer Asymmetrie oder Symmetrie eines Mehrphasenstromnetzes, insbesondere Dreiphasenstromnetz, nach dem Oberbegriff des Anspruchs 1 oder 2 sowie auf eine Schaltungsanordnung nach dem Oberbegriff des Anspruchs 9 oder 10 zur Durchführung des Verfahrens.

Beim Betrieb von Maschinen und Anlagen werden häufig Schaltnetzteile und elektronische Antriebe verwendet. Um die gesetzlichen Anforderungen an die elektromagnetische Verträglichkeit (EMV) zu erreichen, sind Filtermaßnahmen gegen elektrische Störungen nötig.

Hierzu werden EMV-Filter eingesetzt. Diese EMV-Filter weisen mit Schutz - und Potentialausgleichsleiter verbundene Funkentstörkondensatoren auf, durch die Ableitströme entstehen. Ein Ableitstrom ist ein elektrischer Strom, der unter üblichen Betriebsbedingungen in einem unerwünschten Strompfad fließt (Internationales elektrotechnisches Wörterbuch - IEV 195-05-15).

Werden in elektrischen Anlagen zum Sach- und Personenschutz Fehlerstromschutzschalter eingesetzt, können die gegen Erd- oder Massepotential abfließenden Ableitströme den Fehlerstromschutzschalter - insbesondere, wenn dieser zum Personenschutz dient - auslösen.

EMV-Filter für Dreiphasenstromnetze umfassen üblicherweise drei SternpunktKondensatoren, nachfolgend X-Kondensatoren genannt, die jeweils von einem Phasenleiter des Dreiphasenstromnetzes an einen gemeinsamen Sternpunkt geschaltet sind, und einen zwischen dem Sternpunkt und einem Schutzleiter verschalteten Kondensator, nachfolgend Y-Kondensator genannt. Derartige EMV-Filter weisen im stationären Betrieb in der Regel keinen oder nur einen sehr geringen Ableitstrom bei 50 Hz auf.

Der Ableitstrom ergibt sich ausschließlich durch die Toleranz der Kapazitätswerte der X-Kondensatoren der Sternschaltung. Im Idealfall addieren sich die drei Ströme durch die X-Kondensatoren im Sternpunkt zu Null. An dem Y-Kondensator liegt dann kein 50 Hz-Spannungsanteil an, so dass kein 50 Hz-Ableitstrom zum Schutzleiter fließt.

Beim Ein- und Ausschalten des Dreiphasenstromnetzes tritt allerdings das Problem auf, dass die drei Phasenleiter des Dreiphasenstromnetzes mit üblichen Schaltmitteln nicht exakt gleichzeitig zu- oder abgeschaltet werden können. Daher ergibt sich immer eine kurze Zeitspanne, während der nur ein oder zwei Phasenleiter zugeschaltet sind, so dass an dem Sternpunkt eine Wechselspannung anliegt.

Daher fließt durch den Y-Kondensator ein seiner Kapazität proportionaler 50 Hz-Ableitstrom. Dieser kann zu einer Auslösung eines vorgeschalteten FehlerstromSchutzschalters (RCCB) führen, ohne dass ein tatsächlicher Isolationsfehler im Gerät bzw. in der Anlage vorliegt.

Eine gewisse Abhilfe beim Einschalten kann durch ein zeitverzögertes Zuschalten des Y-Kondensators im EMV-Filter erfolgen. Die Grundannahme dabei ist, dass nach Ablauf der Verzögerungszeit alle drei Phasenspannungen stabil anliegen und die Stemspannung, d. h. die Spannung am Sternpunkt, nahe Null liegt. Eine Detektion, ob bei der Zuschaltung des Y-Kondensators im EMV-Filter alle drei Phasenspannungen stabil anliegen, findet nicht statt. Die Abschaltung der Phasenspannungen wird jedoch hierdurch auch nicht detektiert. Es kann somit im Ausschaltmoment wieder eine Fehlauslösung des Fehlerstromschutzschalters durch auftretende Ableitströme auftreten.

Die DE 195 09 658 A1 betrifft ein Verfahren, wobei ein Antriebsgerät aus einem Dreiphasen-Wechselstromnetz gespeist wird und über einen Gleichspannungszwischenkreis mittels elektrischer Ventile eine oder mehrere Antriebsmaschinen versorgt. Bei einer Unterschreitung eines Spannungsschwellwertes im Zwischenkreis wird ein Steuersignal für die Stillsetzung der Maschine gebildet. Um mit geringem Aufwand jegliche Art von Netzausfällen sicher erkennen zu können, wird die ungeglättete Ausgangsspannung des Zwischenkreisgleichrichters mit einem oberen Schwellwert und einem unteren Schwellwert verglichen. Bei Unter- bzw. Überschreiten dieser Schwellenwerte wird eine Kippstufe gesetzt bzw. zurückgesetzt, wobei durch das Signal der gesetzten Kippstufe ein retriggerbares, abfallverzögertes Zeitglied angesteuert wird, aus dessen Ausgangssignal als Netzausfallsignal das Steuersignal für die Stillsetzung der Antriebsmaschinen gebildet wird.

Die US 3,843,908 betrifft ein Verfahren und eine Schaltung zum Erfassen von Fehlerspannungen in einem mehrphasigen Energieversorgungssystem, wobei die Spannungen der Phasenleiter gleichgerichtet werden. Das Verfahren beruht auf der Messung der Phasenspannungen gegen Sternpunkt oder Erde. Dabei wird eine Fehlerspannung jedes der Phasenleiter bis zu einem Wert kleiner als eine vorbestimmte Spannung benutzt, um ein Messelement stromlos zu schalten. Das Messelement umfasst vorzugsweise eine Spule, die mit einer an der Stromversorgung angeschlossenen Last gekoppelt ist. Die Schaltung ist zur Detektion einer Asymmetrie oder Symmetrie von Spannungen der Phasenleiter ausgebildet.

Die US 2014/0233142 A1 betriff eine Vorrichtung und ein Verfahren zur Detektion einer Asymmetrie oder Symmetrie von Phasenspannungen. Die Vorrichtung umfasst eine Vielzahl von Spannungsasymmetriedetektoren, die jeweils eine Phasenspannung aus einer Vielzahl von Phasenspannungen erhalten. Wenn die Phasenspannung asymmetrisch ist, wird ein Unterbrechungssignal ausgegeben. Ferner ist eine Steuereinheit vorgesehen, die eine Phase bestimmt, in der eine Unterbrechung aufgetreten ist. Dabei werden eine Vielzahl von akkumulierter Spannungsinformationen bezüglich der Vielzahl von Phasenspannungen verwendet, die von der Vielzahl von jeweiligen Spannungsasymmetriedetektoren ausgegeben werden.

Die EP 1 819 021 A2 betrifft ein Verfahren und eine Vorrichtung zur Überwachung mehrphasiger Netze und zur Detektion von Phasenausfällen, basierend auf einem Phasenwinkel zwischen den Phasenspannungen. Bei Bedarf wird vor einer Signalausgabe eine Zeitverzögerung vorgesehen.

Davon ausgehend liegt der vorliegenden Erfindung die Aufgabe zugrunde, ein Verfahren und eine Schaltungsanordnung der eingangs genannten Art derart weiterzubilden, dass eine Asymmetrie und/oder Symmetrie der Phasenspannungen insbesondere beim Ein- und Ausschalten eines Mehrphasenstromnetzes auf einfache Weise detektiert werden kann.

Die Aufgabe wird erfindungsgemäß u. a. durch ein Verfahren mit den Merkmalen des Anspruchs 1 gelöst.

Gemäß der Erfindung ist vorgesehen, dass die Asymmetrie oder Symmetrie der Phasenspannungen UL1, UL2, UL3 durch Analyse der pulsierenden Gleichspannung UDC detektiert wird, wobei ein Momentanwert UDC (t) der pulsierenden Gleichspannung UDC mittels eines Momentanwert-Detektors erfasst wird, wobei ein Spitzenwert U_Peak der pulsierenden Gleichspannung UDC ermittelt wird, und wobei der Momentanwert UDC(t) mit einem Relativwert U_Peak in Form eines Anteils A des Spitzenwerts U_Peak mittels eines Komparators verglichen wird, wobei dann, wenn der Momentanwert UDC(t) unterbrechungsfrei über die Dauer der Einschaltverzögerungszeit dT_ev den Relativwert U_Rel nicht unterschreitet, d. h. die Augenblickswerte aller Phasenspannungen UL1, UL2, UL3 unterbrechungsfrei über eine Einschaltverzögerungszeit dT_ev jeweils in etwa gleicher Größe detektiert werden, ein die Symmetrie anzeigendes Detektionssignal erzeugt wird und wobei dann, wenn der Momentanwert UDC(t) einmalig den vorgegebenen Relativwert U Rel unterschreitet, d. h. der Augenblickwert nur einer der Phasenspannungen UL1, UL2, UL3 einen Sollwert unterschreitet, im Wesentlichen verzögerungsfrei ein die Asymmetrie anzeigendes Detektionssignal erzeugt wird.

Die Augenblickswerte der Phasenspannungen werden gemäß der Erfindung nicht gemessen, sondern mittels des Gleichrichters detektiert, um die pulsierende Gleichspannung zu erzeugen. Zur Detektion der Asymmetrie oder Symmetrie der Phasenspannungen wird gemäß der Erfindung die pulsierende Gleichspannung analysiert, die allerdings zu jedem Zeitpunkt aus der Differenz der Augenblickswerte von jeweils zwei oder drei Phasenspannungen resultiert.

Mit anderen Worten zeichnet sich die Erfindung durch einen eigenerfinderischen Gedanken dadurch aus, dass die Asymmetrie oder Symmetrie der Phasenspannungen durch Analyse einer durch Gleichrichtung der Phasenspannungen mittels eines Gleichrichters erzeugten pulsierenden Gleichspannung UDC detektiert wird, wobei ein Momentanwert UDC(t) der pulsierenden Gleichspannung UDC mittels eines Momentanwert-Detektors erfasst wird, wobei ein Spitzenwert U_Peak der pulsierenden Gleichspannung UDC ermittelt wird, und wobei der Momentanwert UDC(t) mit einem Relativwert U_Peak in Form eines Anteils A des Spitzenwerts U_Peak mittels eines Komparators (K) verglichen wird, und wobei dann, wenn der Momentanwert UDC(t) einmalig einen vorgegebenen Relativwert U_Rel unterschreitet, das die Asymmetrie anzeigende Detektionssignal erzeugt wird und wobei das die Symmetrie anzeigende Detektionssignal erst dann wieder erzeugt wird, wenn der Momentanwert UDC(t) unterbrechungsfrei über die Dauer der Einschaltverzögerungszeit dT_ev den Relativwert U_Rel nicht unterschreitet. Dadurch kann ein frühestmöglicher Detektionszeitpunkt sichergestellt werden.

Bei dem erfindungsgemäßen Verfahren wird ausgenutzt, dass eine 6-Puls-Gleichspannung eine Welligkeit von lediglich 20 % bei einer Frequenz von 300 Hz aufweist. Folglich liegt bei Auftreten eines Spannungseinbruchs des Momentanwertes der pulsierenden Gleichspannung von mehr als 20 % unter den über die letzte Millisekunde detektierten Spitzenwert bereits eine Unterbrechung einer Phasenspannung vor. Das erfindungsgemäße Verfahren nutzt diese schnellstmögliche Analyse durch Vergleich des Spitzenwertes U Peak mit dem Momentanwert UDC(t).

Detektion der Augenblickswerte der Phasenspannungen im Sinne der Erfindung bedeutet nicht die Messung der Augenblickswerte z. B. gegen einen Sternpunkt. Gemäß der Erfindung werden die Phasenspannungen gleichgerichtet, wobei ausgenutzt wird, dass in dem Verlauf der pulsierenden Gleichspannung UDC Informationen über den Verlauf der Augenblickswerte der Phasenspannungen enthalten sind. Folglich können aus dem Verlauf der pulsierenden Gleichspannung Detektionssignale zur Detektion einer Symmetrie oder Asymmetrie der Phasenspannungen abgeleitet werden.

Um sicherzustellen, dass das Detektionssignal erst dann erzeugt wird, wenn das Mehrphasennetz symmetrisch ist, d. h. keine Asymmetrie mehr aufweist, ist vorgesehen, dass die Einschaltverzögerungszeit dT_ev mittels eines Zeitgliedes auf eine Zeit im Bereich von 600 ms ≤ dT ev ≤ 1000 ms, vorzugsweise dT_ev = 800 ms eingestellt wird. Besonders bevorzugt liegt der Anteil A des Spitzenwertes U_Peak im Bereich von 0,75 ≤ A ≤ 0,8, und beträgt vorzugsweise A = 0,75. Zur Detektion der Asymmetrie oder Symmetrie ist lediglich ein Komparator erforderlich, der den um den Faktor von A reduzierten Wert U_Peak mit dem Augenblickswert UDC+ (t) mit Bezug auf UDC- (t) vergleicht.

Folglich werden für die Zustandsermittlung, d. h. für die Erzeugung des Detektionssignals keine absoluten Spannungen gemessen, sondern nur das Verhältnis der Momentanspannung UDC(t) der pulsierenden Gleichspannung UDC zu dem Spitzenwert U_Peak der pulsierenden Gleichspannung UDC. Somit ist die Detektorfunktion über einen weiten Bereich unabhängig vom Absolutwert der Netzspannung. Folglich können mit der gleichen Schaltungsanordnung Stromnetze mit Nennspannungen U_N im Bereich von 200 V ≤ U_N ≤ 500 V überwacht werden. Auch die Netzfrequenz hat im Bereich üblicher Netzfrequenzen keinen Einfluss auf die Funktion der Schaltungsanordnung.

Vorzugsweise wird das Detektionssignal bei Ausfall einer Phasenspannung oder periodisch bei Auftreten einer Unterspannung einer Phasenspannung von z. B. 20 % gegenüber einer Sollspannung erzeugt.

Je nachdem, ob ein stromführender Phasenleiter oder ein nicht stromführender Phasenleiter unterbrochen wird, kann das Detektionssignal DS sofort oder erst innerhalb einer Detektionsverzögerungszeit dT_dv nach dem Eintritt der Asymmetrie erzeugt werden. Die Detektionsverzögerungszeit dT dv kann im Bereich 0 ms $\leq$ dT_dv $\leq$ dT_dvmax liegen, wobei die maximale Detektionsverzögerungszeit dT _dvmax durch den Faktor A bestimmt ist und bei einem Faktor A im Bereich von 0,75 $\leq$ A $\leq$ 0,8 im Bereich 3 ms $\leq$ dT_dvmax $\leq$ 4 ms liegt.

Über den Faktor A kann die Empfindlichkeit, d. h. die Detektionsverzögerungszeit dT_dv des Asymmetriedetektors optimiert werden. Im optimalen Fall fällt die Momentanspannung UDC(t) unmittelbar nach Ausfall einer Phasenspannung unter den Relativwert U_Rel = A x U_Peak ab, so dass die Detektionsverzögerungszeit dT_dv = 0 ms beträgt. In diesem Fall wird das Detektionssignal im Wesentlichen verzögerungsfrei generiert. Im ungünstigsten Fall fällt die Phasenspannung zu einem Zeitpunkt ab, zu dem die Summe der verbleibenden Phasenspannungen so groß ist, dass der Momentanwert UDC(t) verzögert, d. h. erst nach Ablauf der Detektionsverzögerungszeit dT_dv, unter den Relativwert U_Rel fällt. Je nach Zeitpunkt des Abschaltens einer Phasenspannung liegt die Detektionsverzögerungszeit dT_dv im Bereich zwischen 0 ms $\leq$ dT_dv $\leq$ 4 ms. Die maximale Detektionszeit kann über den Faktor A eingestellt werden. Bei A = 0,75 ergibt sich eine maximale Detektionszeit dT_dv von 4 ms, die nicht überschritten werden sollte. Ein Faktor A kleiner als 0,75 würde zu längeren Detektionszeiten führen, was unerwünscht ist. Ein Faktor A größer als 0,8 würde zu sehr kurzen Detektionszeiten führen, wodurch die Störanfälligkeit der Schaltung erhöht würde.

Die Ausschaltverzögerungszeit dT_av ergibt sich aus einer Summe der Detektionsverzögerungszeit dT_dv des Asymmetriedetektors und der Verzögerungszeit dT_off_des Zeitgliedes und liegt vorzugsweise im Bereich 0 ms $\leq$ dT_av $\leq$ dT_avmax liegt, wobei vorzugsweise dT avmax = dT_dvmax + dT_off = 4 ms + 0,5 ms = 4,5 ms beträgt.

Zur Bestimmung des Spitzenwertes U_Peak wird vorzugsweise ein Kondensator über eine Diode mit der pulsierenden Gleichspannung UDC aufgeladen, wobei der Relativwert U_Rel mittels eines Spannungsteilers aus dem an dem Kondensator anliegenden Spitzenwert U Peak abgeleitet wird, und wobei der Spannungsteiler vorzugsweise ein einstellbares Teilerverhältnis Tv aufweist mit dem der Relativwert U_Re1 auf den Anteil A des Spitzenwertes U_Peak eingestellt wird.

Vorzugsweise wird das Detektionssignal bei Unterschreiten des Momentanwertes UDC(t) unter den Relativwert U_Rel im Wesentlichen verzögerungsfrei von dem ersten Zustand wie HIGH-Signal in den zweiten Zustand wie LOW-Signal gesteuert, wodurch z. B. eine Schalteinrichtung im Wesentlichen verzögerungsfrei angesteuert werden kann. Ferner wird das Detektionssignal dann, wenn die Phasenspannungen mindestens über die Einschaltverzögerungszeit dT_ev unterbrechungsfrei im Wesentlichen die gleiche Spannung aufweisen, von dem zweiten Zustand wie LOW-Signal in den ersten Zustand wie HIGH-Signal geschaltet.

Damit der Komparator auch bei Wegfall einer Phasenspannung, d. h. z. B. im Zweileiterbetrieb weiter aktiv ist, wird dieser über eine Zeitspanne dT_p, mit dT_p im Bereich von zumindest 50 ms bis 500 ms, mittels einer gepufferten Spannungsversorgung mit Spannung versorgt.

Ferner betrifft die Erfindung einen Asymmetriedetektor zur Detektion einer Asymmetrie oder Symmetrie von Phasenspannungen eines Mehrphasenstromnetzes.

Die Erfindung betrifft zudem einen Asymmetriedetektor zur Detektion einer Asymmetrie oder Symmetrie von Phasenspannungen UL1, UL2, UL3 eines Mehrphasenstromnetzes, wobei der Asymmetriedetektor einen Gleichrichter umfasst, der ausgebildet ist, die Augenblickswerte der Phasenspannungen UL1, UL2, UL3 zu detektieren und die Phasenspannungen UL1, UL2, UL3 gleichzurichten, wobei der Asymmetriedetektor einen Momentanwert-Detektor umfasst, der ausgebildet ist, einen Momentanwert MDC(t) der pulsierenden Gleichspannung UDC des Gleichrichters zu erfassen und einen Komparator umfasst, der ausgebildet ist, den Momentanwert UDC(t) mit einem Schwellwert zu vergleichen, wobei ein Ausgang des Komparators mit einem Eingang der Schalteinrichtung gekoppelt ist. Gemäß der Erfindung ist vorgesehen, dass der Asymmetriedetektor weiter umfasst: einen Spitzenwert-Detektor, der ausgebildet ist, einen Spitzenwert U_Peak der pulsierenden Gleichspannung UDC des Gleichrichters zu erfassen, wobei der Schwellwert ein Relativwert U_Re1 in Form eines Anteils A des Spitzenwertes U_Peak ist, und wobei dann, wenn der Momentanwert UDC(t) unterbrechungsfrei über die Dauer der Einschaltverzögerungszeit dT_ev den Relativwert U_Rel nicht unterschreitet, d. h. die Augenblickswerte aller Phasenspannungen UL1, UL2, UL3 unterbrechungsfrei über eine Einschaltverzögerungszeit dT_ev jeweils in etwa gleicher Größe detektiert werden, ein die Symmetrie anzeigendes Detektionssignal erzeugt wird und wobei dann, wenn der Momentanwert UDC(t) einmalig den Relativwert U_Rel unterschreitet, d. h. der Augenblickswert nur einer der Phasenspannungen UL1, UL2, UL3 einen Sollwert unterschreitet, im Wesentlichen verzögerungsfrei ein die Asymmetrie anzeigendes Detektionssignal erzeugt wird.

Eine eigenerfinderische Ausführung der Erfindung betrifft einen Asymmetriedetektor zur Detektion einer Asymmetrie oder Symmetrie von Phasenspannungen UL1, UL2, UL3 eines Mehrphasenstromnetzes, wobei der Asymmetriedetektor einen Gleichrichter umfasst, der ausgebildet ist, die Phasenspannungen UL1, UL2, UL3 gleichzurichten, wobei der Asymmetriedetektor einen Momentanwert-Detektor umfasst, der ausgebildet ist, einen Momentanwert MDC(t) der pulsierenden Gleichspannung UDC des Gleichrichters zu erfassen und einen Komparator umfasst, der ausgebildet ist, den Momentanwert UDC(t) mit einem Schwellwert zu vergleichen, wobei ein Ausgang des Komparators mit einem Eingang der Schalteinrichtung gekoppelt ist. Der Asymmetriedetektor umfasst: einen Spitzenwert-Detektor, der ausgebildet ist, einen Spitzenwert U_Peak einer an einem Ausgang des Gleichrichters anliegenden pulsierenden Gleichspannung UDC zu erfassen, wobei der Schwellwert ein Relativwert U_Rel in Form eines Anteils A des Spitzenwertes U_Peak ist, und wobei dann, wenn der Momentanwert UDC(t) unterbrechungsfrei über die Dauer der Einschaltverzögerungszeit dT_ev den Relativwert U_Rel nicht unterschreitet, ein die Symmetrie anzeigendes Detektionssignal erzeugt wird und wobei dann, wenn der Momentanwert UDC(t) einmalig den Relativwert U_Rel unterschreitet, im Wesentlichen verzögerungsfrei ein die Asymmetrie anzeigendes Detektionssignal erzeugt wird.

Das Detektionssignal kann besonders bevorzugt zum zeitverzögerten Zuschalten oder unverzüglichen Abschalten von Ableitstrom leitenden Komponenten, wie Kondensatoren eines EMV-Filters, verwendet werden oder allgemein als Meldesignal für eine Symmetrie oder Asymmetrie eines Mehrphasenstromnetzes.

Vorzugsweise umfasst der Asymmetriedetektor einen Gleichrichter, der ausgebildet ist, die Phasenspannungen gleichzurichten, einen Spitzenwert-Detektor, der ausgebildet ist, einen Spitzenwert U_Peak der pulsierenden Gleichspannung UDC des Gleichrichters zu erfassen, einen Momentanwert-Detektor, der ausgebildet ist, einen Momentanwert MDC(t) der pulsierenden Gleichspannung UDC des Gleichrichters zu erfassen, einen Komparator, der ausgebildet ist, den Momentanwert UDC(t) mit dem Spitzenwert U_Peak zu vergleichen.

Ein Ausgang des Komparators ist vorzugsweise mit einem Eingang eines Zeitgliedes gekoppelt, dessen Ausgang mit einem Eingang einer Triggerschaltung wie Schmitt-Trigger verbunden ist und wobei ein Ausgang der Triggerschaltung vorzugsweise über einen Pegelwandler mit dem Eingang der Steuereinheit verbunden ist.

Der Spitzenwert-Detektor umfasst vorzugsweise eine Diode und einen Kondensator, die parallel zu dem Ausgang des Gleichrichters geschaltet sind, wobei parallel zu dem Kondensator ein Spannungsteiler aus Widerständen geschaltet ist und wobei eine Mittelanzapfung des Spannungsteilers mit dem invertierenden Eingang des Komparators verbunden ist.

Der Momentanwert-Detektor zur Erfassung des Momentanwertes UDC(t) der Ausgangsspannung UDC des Gleichrichters ist vorzugsweise aus einem Spannungsteiler aus den Widerständen ausgebildet, der parallel zu den Ausgängen UDC+, UDC- des Gleichrichters geschaltet ist, wobei eine Mittelanzapfung des Spannungsteilers aus den Widerständen mit einem nicht invertierenden Eingang des Komparators verbunden ist.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung von den Zeichnungen zu entnehmenden bevorzugten Ausführungsbeispielen.

Es zeigen:

Fig. 1 ein Prinzipschaltbild der Schaltungsanordnung,

Fig. 2 ein Prinzipschaltbild einer Detektorschaltung,

Fig. 3 ein Prinzipschaltbild eines Umrichters mit einem schaltbaren EMV-Filter,

Fig. 4 ein Diagramm mit Spannungs-Zeit-Verläufen einer stromführenden Phase ohne Abschaltverzögerung, und

Fig. 5 ein Diagramm mit Spannungs-Zeit-Verläufen einer nicht stromführenden Phase mit Abschaltverzögerung.

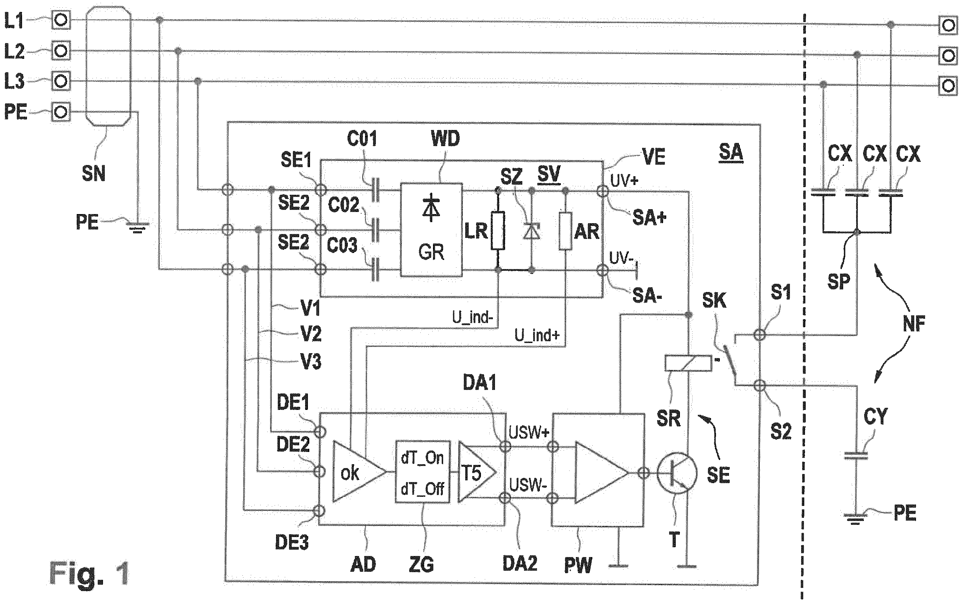

Fig. 1 zeigt rein schematisch eine Schaltungsanordnung SA zum Betrieb eines EMV-Filters NF an einem Dreiphasenstromnetz SN mit Phasenleitern L1, L2, L3 und einem Schutzleiter PE. Das EMV-Filter NF weist drei Sternpunktkondensatoren CX auf, die mit einem Anschluss jeweils mit einem der Phasenleiter L1, L2, L3 des Dreiphasenstromnetzes SN verbunden und mit einem zweiten Anschluss an einen gemeinsamen Sternpunkt SP verschaltet sind. Ferner umfasst das EMV-Filter NF einen Erdungskondensator CY, der mit einem ersten Anschluss mit dem Schutzleiter PE und mit einem zweiten Anschluss über eine Schalteinrichtung SE mit dem Sternpunkt SP verbindbar ist. Die Schalteinrichtung SE umfasst ein Steuerrelais SR mit einem Schaltkontakt SK, der in dem Strompfad des Erdungskondensators CY liegt und mit dem der zweite Anschluss des Erdungskondensators CY mit dem Sternpunkt SP verbindbar ist. Das Steuerrelais SR ist mittels eines Transistors T aktivierbar bzw. deaktivierbar.

Die Schaltungsanordnung SA umfasst einen Asymmetriedetektor AD mit Eingängen DE1, DE2, DE3, die mit den Phasenleitern L1, L2, L3 verbunden sind und mit einem Ausgang DA1, DA2, an dem ein Detektionssignal wie Steuerspannung USW+, USW- zur Aktivierung oder Deaktivierung des Steuerrelais SR anliegt, wobei das Detektionssignal gegebenenfalls über einen Pegelwandler PW mit einem Steuereingang ES der Steuereinheit SE gekoppelt ist.

Der Asymmetriedetektor AD ist ausgebildet, um die Augenblickswerte der Phasenspannungen UL1, UL2, UL3 zu detektieren und bei einem Ausfall oder einem Spannungseinbruch einer oder mehrerer Phasenspannungen UL1, UL2, UL3 um z. B. zumindest 25 % ihres Sollwertes innerhalb einer Ausschaltverzögerungszeit dT_av, die im Bereich von 0 ms ≤ dT_av ≤ 7 ms liegen kann, das Detektionssignal zur Detektion der Asymmetrie zu erzeugen und mittels des Detektionssignals durch nahezu verzögerungsfreies Ansteuern der Schalteinheit SE den den Ableitstrom führenden Strompfad des EMV-Filters zu deaktivieren, so dass durch den Ausfall oder Spannungseinbruch verursachte Ableitströme nicht mehr zum Schutzleiter PE abfließen können. Folglich fließt der Ableitstrom maximal während der Ausschaltverzögerungszeit dT_av, die so kurz eingestellt ist, dass diese kürzer als eine Auslösezeit T_a eines vorgeschalteten Fehlerstromschutzschalters ist, so dass dieser durch den durch das EMV-Filter verursachten unsymmetriebedingten Ableitstrom nicht auslösen kann.

Ferner ist der Asymmetriedetektor AD derart ausgebildet, um das Steuerrelais SR einzuschalten, wenn die drei Phasenspannungen UL1, UL2, UL3 in etwa gleicher Höhe - unterbrechungsfrei über eine Einschaltverzögerungszeit dT_ev anliegen. Die Einschaltverzögerungszeit dT_ev liegt im Bereich 600 ms ≤ dT_ev ≤ 1000 ms und ist vorzugsweise auf T_ev = 800 ms eingestellt, so dass der den Ableitstrom führende Strompfad des EMV-Filters erst dann zugeschaltet wird, wenn das Dreiphasenstromnetz SN sicher eingeschwungen ist und das EMV-Filter normal arbeiten kann.

Die Schaltungsanordnung SA umfasst zudem eine Versorgungseinheit VE mit einer Stromversorgung SV und einem Wechselspannungsdetektor WD.

Die Stromversorgung SV ist ausgebildet, um eine Versorgungsspannung UV+, UV- für das Steuerrelais SR und den Pegelwandler PW bereitzustellen.

Der Wechselspannungsdetektor WD ist ausgebildet, um ein Steuersignal wie Steuerspannung U_ind-, U_ind+ zum Aktivieren oder Deaktivieren des Asymmetriedetektor AD zu generieren. Das Steuersignal zeigt an, ob das Dreiphasenstromnetz SN eine reine Wechselspannung bereitstellt. Die Detektion einer reinen Wechselspannung ist für den Betrieb des EMV-Filters NF notwendig, da nach dem Abschalten der Phasenspannungen UL1, Ul2, UL3 diejenigen Kondensatoren CX, CY des EMV-Filters, die zuletzt an Spannung lagen, aufgrund ihrer in der Regel hohen Kapazitäten und der Größe der meist verwendeten Entladewiderstände nicht vorhersagbare Momentanspannungen bis zu mehreren Sekunden speichern können. Da der Asymmetriedetektor AD auf der Basis der Wechselspannungsverläufe der Phasenspannungen UL1, UL2, UL3 arbeitet, könnten die an den Kondensatoren CX, CY anliegenden Momentanspannungen zu fehlerhaftem Verhalten führen. Folglich wird der Asymmetriedetektor AD nur dann aktiviert, wenn das Dreiphasenstromnetz eine reine Wechselspannung bereitstellt.

Die Versorgungseinheit VE ist eingangsseitig über Eingänge SE1, SE2, SE3 mit den Phasenleitern L1, L2, L3 verbunden. Ausgangsseitig weist die Versorgungseinheit VE einen Spannungsausgang SA+, SA- auf, an dem eine Versorgungsspannung UV+, UVanliegt, mittels der das Steuerrelais SR und der Pegelwandler PW versorgt werden.

Die Stromversorgung SV umfasst einen Gleichrichter GR, vorzugsweise in Form eines B6-Brückengleichrichters, dessen Eingänge jeweils über einen Kondensator C01, C02, C03 mit einem Phasenleiter L1, L2, L3 verbunden sind. Ein Ausgang des Gleichrichters GR ist mit dem Spannungsausgang SA+, SA- verbunden.

Parallel zu dem Ausgang des Gleichrichters GR ist ein Lastwiderstand LR und eine Stabilisierungsdiode SZ geschaltet, die auch den Spannungsausgang SA+, SA- bilden.

Das Steuersignal U_ind-, U_ind+ wird über einen Ausgangswiderstand AR ausgekoppelt, der mit einem ersten Anschluss mit dem Spannungsausgang SA+ verbunden ist. Ein zweiter Anschluss des Ausgangswiderstandes AR bildet zusammen mit Massepotential einen Ausgang für das Steuersignal U_ind+, U ind-, mit dem das Anliegen der reinen Wechselspannung angezeigt wird.

Die Kondensatoren C01, C02, C03 wirken als hohe kapazitive Vorwiderstände und ermöglichen über den Brückengleichrichter GR und den Lastwiderstand LR eine unkomplizierte Reduktion einer ggf. an den Kondensatoren CX, CY anliegenden ca. 600V hohen Gleichspannung auf einen für das Steuerrelais SR geeigneten Spannungswert, ohne Erzeugung von Wärme in ohmschen Widerständen.

Die Stabilisierungsdiode SZ begrenzt die Spannung über dem Lastwiderstand LR auf die Versorgungsspannung UV+, UV- des Steuerrelais SR, wodurch der Betrieb der Schaltung an Spannungsnetzen von 200 bis 500V ermöglicht wird.

Weiterhin bildet der Lastwiderstand LR mit den Kondensatoren C01, C02, C03 ein Differenzierglied mit einer Zeitkonstanten im Bereich von 5 ms. Bei Wegfall von zwei oder aller drei Phasenspannungen UL1, UL2, UL3, genauer bei Wegfall der dU/dt-Komponente, bricht die Spannung an dem Lastwiderstand RL zusammen. Eine auf den Phasenleitern L1, L2, L3 verbleibende Gleichspannung kann somit nicht an den Lastwiderstand LR gelangen.

Über den Ausgangswiderstand AR wird das Steuersignal U_ind+/U_ind- ausgekoppelt, mittels dem ein Steuerelement wie Optokoppler OK zur Aktivierung bzw. Deaktivierung des Asymmetriedetektors AD angesteuert wird. Bei Anliegen einer Wechselspannung an dem Gleichrichter GR wird der Optokoppler OK durchgesteuert und der Asymmetriedetektor AD wird in einen wirksamen Zustand geschaltet.

Bei Wegfall des Steuersignals U_ind+, U ind-, d. h. bei Anliegen einer hohen Gleichspannung an dem Gleichrichter GR, wird der Asymmetriedetektor AD in einen unwirksamen Zustand geschaltet. Somit ist eine Fehldetektion infolge der Restspannungen an den Kondensatoren CX ausgeschlossen.

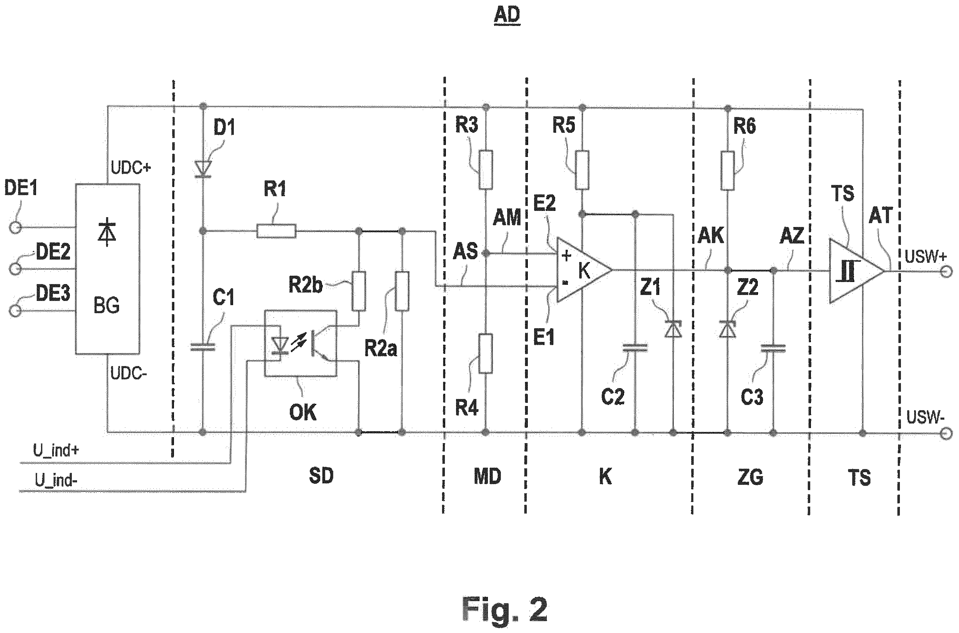

Fig. 2 zeigt ein Prinzipschaltbild des eigenerfinderischen Asymmetriedetektors AD. Dieser umfasst einen Gleichrichter BG in Form eines B6-Brückengleichrichters, der eingangsseitig mit den Anschlüssen DE1, DE2, DE3 die über Verbindungsleitungen V1, V2, V3 mit jeweils einem Phasenleiter L1, L2, L3 des Dreiphasenstromnetzes SN verbunden ist.

Die an den Ausgängen UDC+ und UDC- des Gleichrichters BG anliegende pulsierende Gleichspannung UDC wird mittels eines Spitzenwert-Detektors SD und eines Momentanwert-Detektors MD erfasst. Ein Ausgang AS des Spitzenwert-Detektors SD ist mit einem invertierenden Eingang E1 eines Komparators K und ein Ausgang AM des Momentanwert-Detektors MD ist mit einem nichtinvertierenden Eingang E2 des Komparators K verbunden.

Der Spitzenwert-Detektor SD ist zur Erfassung eines Spitzenwertes U_Peak der pulsierenden Gleichspannung UDC des Gleichrichters BG ausgebildet und umfasst eine Diode D1, deren Anode mit dem Ausgang UDC+ verbunden ist und deren Kathode über einen Kondensator C1 mit dem Ausgang UDC- verbunden ist. Der Kondensator C1 wird über die Diode D1 auf den Spitzenwert U_Peak der pulsierenden Gleichspannung UDC aufgeladen.

Ein zwischen der Kathode der Diode D1 und dem Kondensator C1 liegender Anschluss ist über einen Spannungsteiler mit den Widerständen R1 und R2a an den Ausgang UDCgeschaltet. Eine Mittelanzapfung des Spannungsteilers aus den Widerständen R1, R2a bildet den Ausgang AS, der mit dem invertierenden Eingang E1 des Komparators K verbunden ist. Die Widerstände R1, R2a sind üblicherweise so ausgelegt, dass eine Vergleichsmessung an dem Komparator optimal wirksam ist.

Optional kann ein Spannungsteilerzweig mit einem zusätzlichen Widerstand R2b vorgesehen sein, der mittels eines Schaltelementes OK wie Optokoppler parallel zu dem Widerstand R2a schaltbar ist. Die Spitzenwertspannung U_Peak kann in diesem Fall entweder über den Spannungsteiler R1, R2a oder über den Spannungsteiler R1, R2a, R2b in geeigneter Weise geteilt und über den Ausgang AS dem invertierenden Eingang E1 des Komparators K zugeführt werden. Der Optokoppler OK weist einen Steuereingang auf, an dem das Steuersignal U_in+, U_ind- des Wechselspannungsdetektors WD anliegt. Bei Anliegen einer Wechselspannung an dem Gleichrichter GR wird der Optokoppler OK durchgesteuert und der Spannungsteiler R1, R2a, R2b ist wirksam. Dieser ist so ausgelegt, dass die Vergleichsmessung an dem Komparator optimal wirksam ist. Bei Wegfall des Steuersignals U_in+, U_in- erfolgt eine Verstimmung des Spannungsteilers, wobei der Spannungsteiler R1, R2a wirksam ist. Dieser liefert eine Spannung, die den Komparator stets auf LOW-Potential hält, so dass eine Fehlfunktion infolge von Restspannungen an den Kondensatoren CX ausgeschlossen ist.

Der Momentanwert-Detektor MD ist zur Erfassung eines Momentanwertes UDC(t) der pulsierenden Gleichspannung UDC des Gleichrichters BG ausgebildet und umfasst einen Spannungsteiler aus einer Reihenschaltung von Widerständen R3 und R4, die parallel zu der Ausgangsspannung an den Ausgängen UDC+, UDC- liegen. Eine Mittelanzapfung des Spannungsteilers der Widerstände R3, R4 bildet den Ausgang AM und ist mit dem nicht invertierenden Eingang E2 des Komparators K verbunden.

Der Komparator K ist zum Vergleich der an den Eingängen E1, E2 anliegenden Spannungen ausgebildet und wird über eine Pufferschaltung, umfassend den Widerstand R5, den Kondensator C2 und die Diode Z1, mit einer gepufferten Spannung versorgt. Somit kann ein Wegfall der Gleichspannung UDC bis zu mehreren 100 ms überbrückt werden und die Auswertung der Spannungen an dem Komparator K kann fehlerfrei erfolgen. Dies ist zur sicheren Detektion z. B. eines Zweiphasenbetriebs erforderlich.

Ein Ausgang AK des Komparators K ist mit einem Zeitglied ZG verbunden, umfassend einen Widerstand R6, der mit dem Ausgang UDC+ des Gleichrichters BG verbunden ist und einen Kondensator C3, der mit dem Ausgang UDC- des Gleichrichters BG verbunden ist. Parallel zu dem Kondensator C3 ist eine Z-Diode Z2 geschaltet.

Ein Ausgang AZ des Zeitgliedes ZG ist mit einem Eingang ET einer Triggerschaltung TS wie Schmitt-Trigger verbunden, dessen Ausgang AT über einen Pegelwandler PW mit einem Steuereingang B wie Basis des Schaltelementes T wie Schalttransistors verbunden ist. Über den Schalttransistor T ist ein erster Anschluss des Schaltrelais SR mit dem Ausgang SA- der Stromversorgung SV verbindbar. Ein zweiter Anschluss des Schaltrelais SR ist mit einem Ausgang SA+ der Stromversorgung SV verbunden.

Die Funktion der Schaltungsanordnung SA ist wie folgt. Die Augenblickswerte der Phasenspannungen UL1, UL2, UL3 werden detektiert und in Abhängigkeit der Augenblickswerte der Phasenspannungen UL1, UL2, UL3 wird der Kontakt SK des Steuerrelais SR im Strompfad des Kondensators CY geschlossen oder geöffnet, um einen Ableitstrom durch den Kondensator CY zu ermöglichen oder zu verhindern.

Wird das Anliegen aller drei Phasenspannungen UL1, UL2, UL3 in etwa gleicher Höhe unterbrechungsfrei über eine Einschaltverzögerungszeit dT_ev von mindestens z. B. 800 ms erkannt, wird das Steuerrelais SR aktiviert, so dass der Kondensator CY mit dem Sternpunkt SP verbunden und folglich das EMV-Filter NF vollumfänglich funktionstüchtig ist.

Sobald auch nur eine der drei Phasenspannungen ausfällt oder ihren Sollwert um zumindest 25 % unterschreitet, wird das Steuerrelais SR nahezu verzögerungsfrei abgeschaltet, wodurch der Strompfad des Kondensators CY geöffnet und der Ableitstrom unterbrochen wird. Dadurch wird erreicht, dass zu einem frühestmöglichen Zeitpunkt, zu dem noch nicht alle drei Phasenspannungen UL1, UL2, UL3 abgeschaltet sind, der Kondensator CY von dem Sternpunkt SP getrennt wird mit der Folge, dass Ableitströme nicht mehr zu dem Schutzleiter PE fließen können und somit eine Fehlauslösung des Fehlerstromschutzschalters auch beim Abschalten verhindert wird, denn durch die schnelle Detektion und die augenblickliche Abschaltung fließen unsymmetriebedingte Ableitströme nur für einen kurzen Zeitabschnitt, der kleiner ist als eine Auslösezeit T_a des Fehlerstromschutzschalters.

Um einen frühestmöglichen Detektionszeitpunkt zu erzielen, werden die Phasenspannungen UL1, UL2, UL3 gleichgerichtet und der zeitliche Verlauf der an den Ausgängen UDC+, UDC- des Gleichrichters BG, insbesondere 6-Puls-Gleichrichters, anliegenden pulsierenden Gleichspannung UDC ausgewertet. Der Erfindung liegt der Gedanke zugrunde, dass die 6-Puls-Gleichspannung UDC eine Welligkeit von lediglich 20 % bei 300 Hz aufweist und dass bei Auftreten eines Spannungseinbruchs des Momentanwertes UDC(t) der pulsierenden Gleichspannung UDC von mehr als 25 % unter den über die letzte Millisekunde detektierten Spitzenwert U_Peak der pulsierenden Gleichspannung UDC bereits eine Unterbrechung eines Phasenleiters vorliegt.

Der erfindungsgemäße Asymmetriedetektor AD nutzt dieses schnellstmögliche Analyseverfahren, indem der Momentanwert UDC(t) der pulsierenden Gleichspannung UDC mit einem aus dem Spitzenwert U_Peak abgeleiteten Relativwert U_Rel verglichen wird. Wobei der Relativwert U_Rel durch Auslegung des Spannungsteilers R1, R2a, R2b bestimmt wird mit A * U_Peak, wobei A im Bereich $0{,}75 \leq A \leq 0{,}8$, vorzugsweise A= 0,75 beträgt.

Der Spannungsteiler R1, R2a, R2b sowie der Spannungsteiler R3, R4 sind derart ausgelegt, dass der Ausgang AK des Komparators K so lange auf HIGH-Signal liegt, bis der Momentanwert UDC(t) der pulsierenden Gleichspannung UDC einen Wert unterschreitet, der 75 % der Spitzenspannung U_Peak entspricht. In diesem Zustand schaltet der Ausgang AK auf LOW-Signal. Dieser Zustand tritt bei Wegfall einer Phasenspannung UL1, UL2, UL3 oder auch periodisch bei Auftreten einer Unterspannung von etwa 20 % auf einer der Phasenleitungen auf.

Da für die Zustandsermittlung keine absoluten Spannungen gemessen werden, sondern nur das Verhältnis aus Momentanspannung bzw. Momentanwert UDC(t) zur Spitzenspannung bzw. Spitzenwert U_Peak in die Berechnung eingeht, ist die Detektorfunktion über einen weiten Bereich unabhängig vom Absolutwert der Phasenspannung. Es können mit der gleichen Schaltung Netze von 200 V - 500 V überwacht werden. Auch die Netzfrequenz hat im Bereich gebräuchlicher Netzfrequenzen keinen Einfluss auf die Funktion der Schaltung.

Am Ausgang AK des Komparators K mit vorzugsweise OpenCollector-Konfiguration bewirkt das Zeitglied ZG bei HIGH-Signal eine langsame Ladung des Kondensators C3 über den Widerstand R6 über die Einschaltverzögerungszeit dT_ev, die im Bereich $600\ ms \leq dT\_ev \leq 1000\ ms$ liegen kann, vorzugsweise dT_ev = 800 ms beträgt. Die Einschaltverzögerungszeit dT_ev entspricht der Zeitverzögerung dT_On des Zeitgliedes ZG.

Bei LOW-Signal am Ausgang AK des Komparators K erfolgt während einer Zeitverzögerung dT_Off des Zeitgliedes ZG, die im Bereich $0{,}3 \leq dT\_Off \leq 0{,}8$ liegt, vorzugsweise dT_Off = 0,5 ms beträgt, eine nahezu schlagartige Entladung des Kondensators C3 über den Ausgangstransistor des Komparators K. Durch die Zeitverzögerung dT_Off können Auslösungen aufgrund von transienten Spannungsspitzen der Netzspannung unterdrückt werden.

Der an sich bekannte Schmitt-Trigger ST schaltet bei einer geeigneten Spannung an dem Kondensator C3 in den HIGH-Zustand und erzeugt so ein universell verwendbares Steuersignal USW+/USW-, das zur Aktivierung/Deaktivierung des Steuerrelais SR aber auch allgemein als Meldesignal für die Symmetrie bzw. Asymmetrie der Phasennetzspannungen einsetzbar ist.

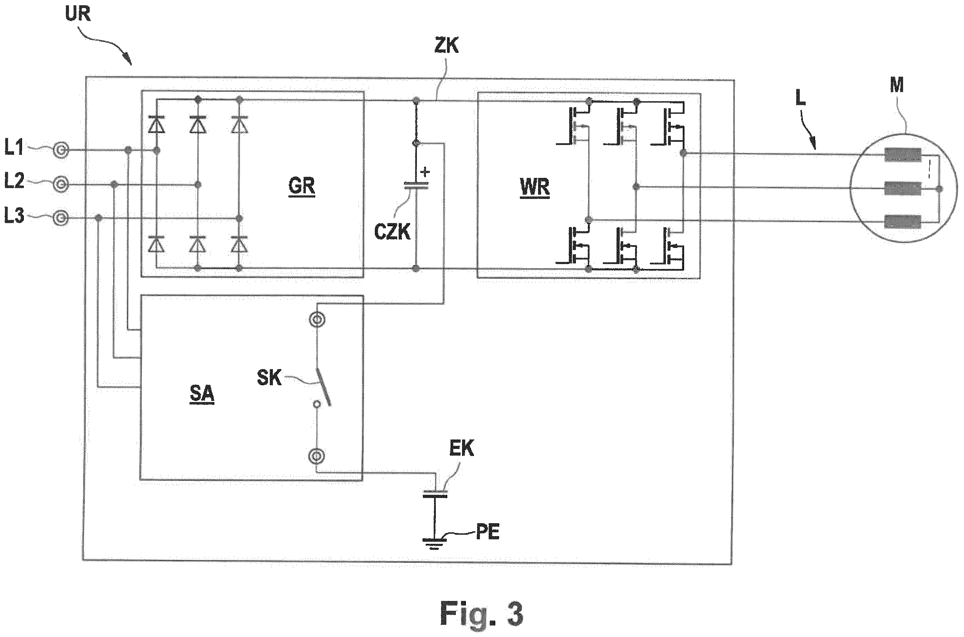

Fig. 3 zeigt einen Umrichter UR mit einem Gleichrichter GR, der eingansseitig mit den Phasenleitern L1, L2, L3 des Mehrphasenstromnetz SN und ausgangsseitig über einen Gleichspannungszwischenkreis ZK mit einem Wechselrichter WR verbunden ist. Der Gleichspannungszwischenkreis ZK umfasst einen Glättungskondensator CZK, der parallel zu einem Ausgang des Gleichrichters GR liegt. An einem Ausgang des Wechselrichters WR ist über eine Leitung L ein Antrieb M angeschlossen.

Zur Entstörung des Wechselrichters WR ist ein EMV-Filter in Form eines Kondensators EK vorgesehen, der in einem Strompfad angeordnet ist, der mit einem ersten Anschluss mit einem Pol des Gleichspannungszwischenkreises ZK und mit einem zweiten Anschluss mit dem Schutzleiter PE verbunden ist. Gemäß der Erfindung ist in dem Strompfad des Kondensators EK ein Schaltkontakt SK angeordnet, der in Abhängigkeit der Symmetrie oder Asymmetrie der Phasenspannungen UL1, UL2, UL3 geschaltet wird. Wird das Anliegen aller drei Phasenspannungen in etwa gleicher Höhe - unterbrechungsfrei über mindestens z. B. 800 ms erkannt, wird der Schaltkontakt aktiviert und das EMV-Filter arbeitet normal. Sobald auch nur eine der drei Phasenspannungen ihren Sollwert mindestens um z. B. 25 % unterschreitet, wird der Schaltkontakt SK nahezu verzögerungsfrei abgeschaltet.

Der Schaltkontakt SK ist Teil der Schaltungsanordnung SA gemäß Fig. 1 und Fig. 2. Die Schaltungsanordnung kann in dem Umrichter UR integriert sein.

Gemäß der Erfindung werden die Augenblickswerte der Phasenspannungen nicht gemessen. Jedoch werden die Augenblickswerte mittels des 6-Wege-Gleichrichters detektiert und gleichgerichtet. Die 6-Wege-Gleichrichtung liefert in Bezug auf den Sternpunkt folgende Spannungen:

1.

$$\text{Die positive Spannung } UDC+(t) = MAX[U1(t); U2(t); U3(t)]$$

2.

Die negative Spannung UDC-(t) = MIN [U1(t); U2(t); U3(t)]

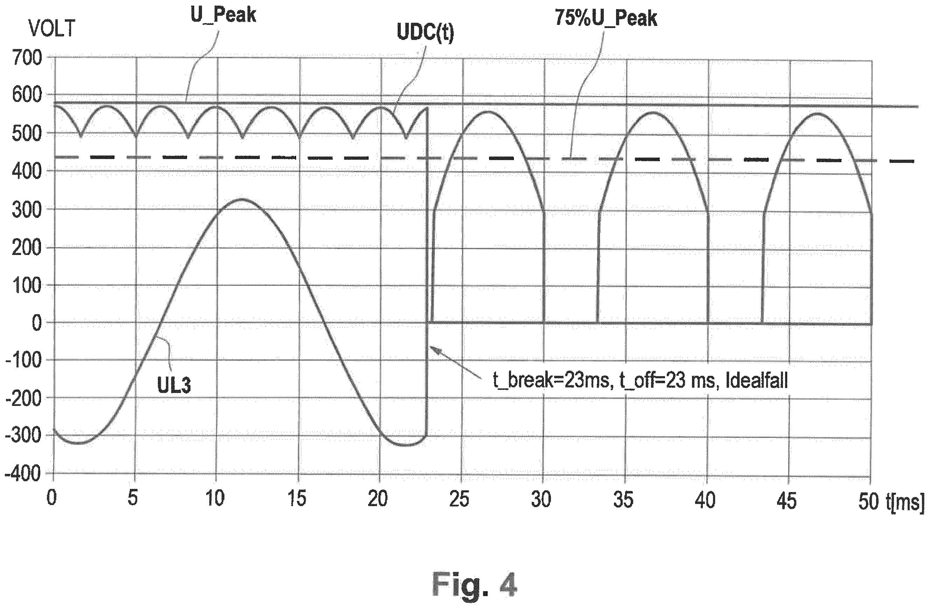

Fig. 4 zeigt den zeitlichen Verlauf einer stromführenden Phasenspannung UL3, den Momentanwert UDC+(t) der pulsierenden Gleichspannung UDC des Gleichrichters BG sowie den Spitzenwert U_Peak der pulsierenden Gleichspannung UDC unter idealen Bedingungen. Die 6-Wege-Gleichrichtung einer im Wesentlichen perfekt symmetrischen sinusförmigen 3-Phasen Netzspannung führt immer zu einer gleichgerichteten Spannung UDC+ bezogen auf UDC- mit 15,3 % Welligkeit bei 300 Hz. Bereits eine Absenkung einer der drei Phasenspannungen um 10 % führt zu einer Erhöhung der Welligkeit auf 23,6 %.

Eine Messung der Augenblickswerte der drei Phasenspannungen gegen den Sternpunkt erfolgt nicht. Kennzeichen der Erfindung ist die Detektion der Asymmetrie oder Symmetrie ohne Messung der Augenblickswerte gegen Neutralleiter N, da beim Einsatz der Schaltung ein Neutralleiter meist nicht zur Verfügung steht.

Das Messverfahren beruht vielmehr auf der Erfassung zweier Messgrößen der pulsierenden Gleichspannung UDC, nämlich dem Maximalwert U_Peak, der durch Spitzenwertgleichrichtung ermittelt wird, sowie dem Momentanwert UDC(t) der pulsierenden Gleichspannung UDC. Folglich ist die Grundlage des erfindungsgemäßen Verfahrens die Erzeugung der pulsierenden Gleichspannung UDC und die Analyse des Momentanwertes UDC+ (t) in Bezug auf UDC- (t).

Eine Asymmetrie liegt dann vor, sobald der Momentanwert UDC (t) der pulsierenden Gleichspannung UDC in Bezug auf die negative Ausgangsspannung UDC- (t) den Relativwert U_Re1 mit U_Re1 = A * U_Peak, mit A im Bereich von 0,75 ≤ 0,867, unterschreitet.

Zum Zeitpunkt t_break = 23 ms wird die Phasenspannung UL3 unterbrochen, wodurch der Momentanwert UDC(t) der pulsierenden Gleichspannung UDC zum selben Zeitpunkt t_off = 23 ms verzögerungsfrei unter den Relativwert U_Re1 abfällt. Der Spannungseinbruch der Phasenspannung UL3 und das Unterschreiten des Momentanwertes UDC(t) der pulsierenden Gleichspannung UDC unter den Relativwert U_Re1 = 0,75 * U_Peak erfolgt im Idealfall verzögerungsfrei, d. h. mit einer Detektionsverzögerungszeit dT_dv = 0 ms.

Der Relativwert U_Re1 der Spitzenspannung U_Peak liegt an dem invertierenden Eingang E1 des Komparators K an, während der Momentanwert UDC(t) der pulsierenden Gleichspannung UDC über den Spannungsteiler R3, R4 an dem nicht invertierenden Eingang E2 des Komparators K anliegt. Der Komparator K vergleicht den Relativwert U_Re1 mit dem Momentanwert UDC(t). Sobald der Momentanwert UDC(t) den Relativwert U_Rel, der 75 % des Spitzenwertes U_Peak beträgt, unterschreitet, schaltet der Komparator K über den Pegelwandler PW den Transistor T unverzüglich ab, wodurch das Steuerrelais SR ggf. nach einer Reaktionszeit T_r von ca. T_r = 2,5 ms abfällt und der Strompfad des Y-Kondensators CY des EMV-Filters NF geöffnet wird, mit der Folge, dass keine Ableitströme mehr fließen können. Folglich kann ein Ableitstrom nicht länger als dT_dv + dT_Off + T_r = 0 ms + 0,5 ms + 2,5 ms = 3 ms fließen. Da die Auslösezeit T_a eines Fehlerstromschutzschalters üblicherweise im Bereich von T_a > 8 ms liegt, löst dieser noch nicht aus.

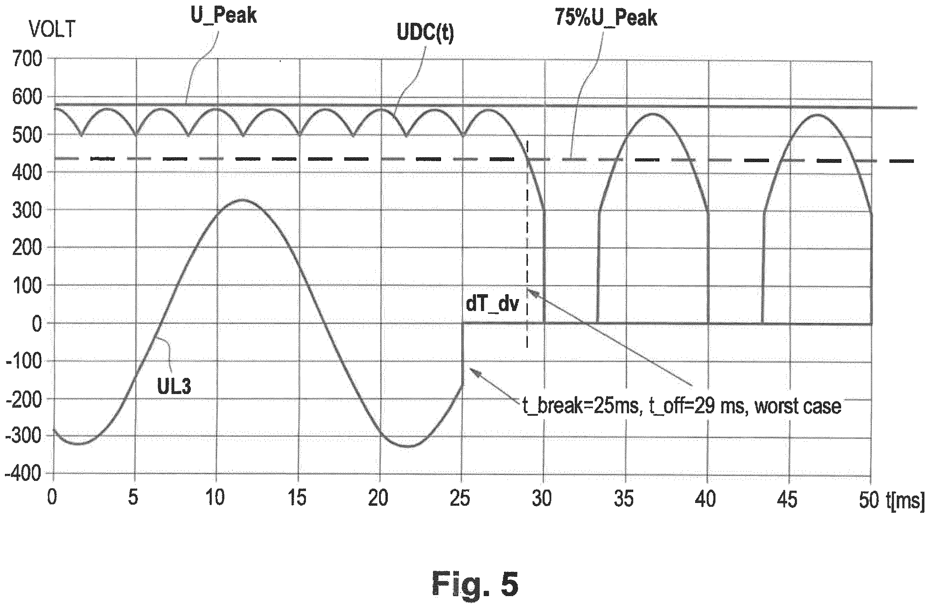

Fig. 5 zeigt Spannungs-Zeitverläufe einer nicht stromführenden Phasenspannung UL3, des Spitzenwertes U_Peak der pulsierenden Gleichspannung sowie die pulsierende Gleichspannung UDC unter "Worst Case" Bedingungen, wobei die Phasenspannung UL3 zu einem Zeitpunkt t_break = 25 ms abgeschaltet wird. Allerdings fällt der Momentanwert UDC(t) nicht unmittelbar ab, da ab dem Zeitpunkt t_break die Summe der verbleibenden Phasenspannungen größer ist als der Relativwert U_Re1 = A * U_Peak. Erst zum Zeitpunkt t_off = 29 ms, wenn auch die weiteren Phasenspannungen sinken, wird der Relativwert 0,75 * U_Peak unterschritten. Die Detektion erfolgt somit erst nach einer Detektionsverzögerungszeit dT_dv von 4 ms. Zusammen mit der Verzögerungszeit T_Off des Zeitgliedes ZG von ca. T_Off = 0,5 ms, der Reaktionszeit T_r des Steuerrelais SR von ca. T_r = 2,5 ms kann ein unsymmetriebedingter Ableitstrom jedoch nicht länger als dT_dv + dT_Off + T_r = 4 ms + 0,5 ms + 2,5 ms = 7 ms fließen und den Fehlerstromschutzschalter nicht auslösen.

Die erfindungsgemäße Schaltungsanordnung eliminiert auch durch Schaltelemente bedingte Prellvorgänge und Kurzzeitunterbrechungen, da jede Unterbrechung einer Phase nach einer maximalen Detektionsverzögerungszeit T_dvmax von 4 ms einen Neustart der Einschaltverzögerungszeit von z. B. 800 ms auslöst.

Fig. 1 zeigt, dass die Schaltungsanordnung SA nur die drei Phasenleiter L1, L2, L3 des Dreiphasenstromnetzes SN benutzt, wobei eine Verbindung zum Neutralleiter oder Schutzleiter PE nicht besteht. Die Eigenschaften des EMV-Filters NF bzgl. Entstörwirkung und Hochspannungsfestigkeit gegen den Schutzleiter PE bleiben unberührt. Mit der Schaltungsanordnung SA können EMV-Filter NF und die nachgeschalteten Verbraucher problemlos an einem Fehlerstromschutzschalter betrieben werden. Eine Fehlabschaltung ist nahezu ausgeschlossen.

**Patentansprüche**

**1.** Verfahren zur Detektion einer Asymmetrie oder Symmetrie von Phasenspannungen (UL1, UL2, UL3) eines Mehrphasenstromnetzes (SN),

wobei die Augenblickswerte der Phasenspannungen (UL1, UL2, UL3) mittels eines Asymmetriedetektors (AD) detektiert werden indem der Asymmetriedetektor (AD) einen Gleichrichter (BG) umfasst, mittels dem durch Gleichrichtung der Phasenspannungen (UL1, UL2, UL3) eine pulsierende Gleichspannung UDC erzeugt wird, wobei die Asymmetrie oder Symmetrie der Phasenspannungen (UL1, UL2, UL3) durch Analyse der pulsierenden Gleichspannung UDC detektiert wird, wobei ein Momentanwert UDC(t) der pulsierenden Gleichspannung UDC mittels eines Momentanwert-Detektors (MD) erfasst wird,

und wobei der Momentanwert UDC(t) mit einem Schwellwert mittels eines Komparators (K) verglichen wird,

**dadurch gekennzeichnet,**

**dass** ein Spitzenwert U_Peak der pulsierenden Gleichspannung UDC(t) ermittelt wird, dass der Schwellwert ein Relativwert U_Rel = A x U_Peak in Form eines Anteils A des Spitzenwertes U_Peak ist,

wobei dann, wenn der Momentanwert UDC(t) unterbrechungsfrei über die Dauer der Einschaltverzögerungszeit dT_ev den Relativwert U_Rel nicht unterschreitet, d. h. die Augenblickswerte aller Phasenspannungen (UL1, UL2, UL3) unterbrechungsfrei über eine Einschaltverzögerungszeit dT_ev jeweils in etwa gleicher Größe detektiert werden, ein die Symmetrie anzeigendes Detektionssignal erzeugt wird und

wobei dann, wenn der Momentanwert UDC(t) einmalig den vorgegebenen Relativwert U_Rel unterschreitet, d. h. der Augenblickswert nur einer der Phasenspannungen (UL1, UL2, UL3) einen Sollwert unterschreitet, im Wesentlichen verzögerungsfrei ein die Asymmetrie anzeigendes Detektionssignal DS erzeugt wird.

2. Verfahren zur Detektion einer Asymmetrie oder Symmetrie von Phasenspannungen (UL1, UL2, UL3) eines Mehrphasenstromnetzes (SN), wobei die Phasenspannungen (UL1, UL2, UL3) mittels eines Asymmetriedetektors (AD) detektiert werden, indem der Asymmetriedetektor (AD) einen Gleichrichter (BG) umfasst, mittels dessen durch Gleichrichtung der Phasenspannungen (UL1, UL2, UL3) eine pulsierende Gleichspannung UDC erzeugt wird,

wobei die Asymmetrie oder Symmetrie der Phasenspannungen durch Analyse der pulsierenden Gleichspannung UDC detektiert wird, wobei ein Momentanwert UDC(t) der pulsierenden Gleichspannung UDC mittels eines Momentanwert-Detektors erfasst wird, und wobei der Momentanwert UDC(t) mit einem Schwellwert mittels eines Komparators (K) verglichen wird,

**dadurch gekennzeichnet,**

**dass** ein Spitzenwert U_Peak der pulsierenden Gleichspannung UDC ermittelt wird, dass der Schwellwert ein Relativwert U_Rel = A x U_Peak in Form eines Anteils A des Spitzenwertes U_Peak ist,

und wobei dann, wenn der Momentanwert UDC(t) einmalig einen vorgegebenen Relativwert U_Re1 unterschreitet, das die Asymmetrie anzeigende Detektionssignal erzeugt wird und wobei das die Symmetrie anzeigende Detektionssignal erst dann wieder erzeugt wird, wenn der Momentanwert UDC(t) unterbrechungsfrei über die Dauer der Einschaltverzögerungszeit dT_ev den Relativwert U_Rel nicht unterschreitet.

3. Verfahren nach Anspruch 1 oder 2,
   **dadurch gekennzeichnet,**
   **dass** die Einschaltverzögerungszeit dT_ev mittels eines Zeitgliedes (ZG) auf eine Zeit im Bereich von 600 ms $\leq$ dT_ev $\leq$ 1000 ms, vorzugsweise dT_ev = 800 ms eingestellt wird.

4. Verfahren nach Anspruch 1 oder 2,
   **dadurch gekennzeichnet,**
   **dass** der Anteil A im Bereich von 0,75 $\leq$ A $\leq$ 0,8 liegt, vorzugsweise A = 0,75 beträgt.

5. Verfahren nach zumindest einem der vorhergehenden Ansprüche,
   **dadurch gekennzeichnet,**
   **dass** das die Asymmetrie anzeigende Detektionssignal DS bei Ausfall einer Phasenspannung (UL1, UL2, UL3) oder periodisch bei Auftreten einer Unterspannung einer Phasenspannung (UL1, UL2, UL3) von z. B. 20 % gegenüber einer Sollspannung erzeugt wird.

6. Verfahren nach zumindest einem der vorhergehenden Ansprüche,
   **dadurch gekennzeichnet,**
   **dass** das die Asymmetrie anzeigende Detektionssignal DS innerhalb einer Detektionsverzögerungszeit dT_dv nach dem Eintritt der Asymmetrie erzeugt wird, wobei die Detektionsverzögerungszeit dT_dv im Bereich 0 ms $\leq$ dT_dv $\leq$ dT_dvmax liegt, wobei die maximale Detektionsverzögerungszeit dT_dvmax durch den Faktor A bestimmt ist und bei einem Faktor A im Bereich von 0,75 $\leq$ A $\leq$ 0,8 im Bereich 3 ms $\leq$ dT_dvmax $\leq$ 4 ms liegt und vorzugsweise bei A = 0,75 dT_dvmax = 4 ms beträgt.

**7.** Verfahren nach zumindest einem der vorhergehenden Ansprüche,
**dadurch gekennzeichnet,**
**dass** zur Bestimmung des Spitzenwertes U_Peak ein Kondensator (C1) über eine Diode (D1) mit der pulsierenden Gleichspannung UDC aufgeladen wird, dass der Relativwert U_Re1 mittels eines Spannungsteilers (R1, R2a, R2b) aus dem an dem Kondensator (C1) anliegenden Spitzenwert U_Peak abgeleitet wird, wobei der Spannungsteiler (R1, R2a, R2b) vorzugsweise ein einstellbares Teilerverhältnis STV aufweist mit dem der Relativwert U_Rel auf den Anteil A des Spitzenwertes U_Peak eingestellt wird.

**8.** Verfahren nach zumindest einem der vorhergehenden Ansprüche,
**dadurch gekennzeichnet,**
**dass** der Komparator (K) bei Wegfall der pulsierenden Gleichspannung UDC für eine Zeitspanne dT_p, mit dT_p im Bereich von zumindest 50 ms bis 500 ms, mittels einer gepufferten Spannungsversorgung mit Spannung versorgt wird.

**9.** Asymmetriedetektor (AD) zur Detektion einer Asymmetrie oder Symmetrie von Phasenspannungen (UL1, UL2, UL3) eines Mehrphasenstromnetzes (SN),

wobei der Asymmetriedetektor (AD) einen Gleichrichter (BG) umfasst, der ausgebildet ist, die Augenblickswerte der Phasenspannungen (UL1, UL2, UL3) zu detektieren und die Phasenspannungen (UL1, UL2, UL3) gleichzurichten,
wobei der Asymmetriedetektor (AD) einen Momentanwert-Detektor (MD) umfasst, der ausgebildet ist, einen Momentanwert MDC(t) der pulsierenden Gleichspannung UDC des Gleichrichters (BG) zu erfassen, und
wobei der Asymmetriedetektor (AD) einen Komparator (K) umfasst, der ausgebildet ist, den Momentanwert UDC(t) mit einem Schwellwert zu vergleichen, wobei ein Ausgang (A1) des Komparators (K) mit einem Eingang einer Schalteinrichtung (SE) gekoppelt ist,
**dadurch gekennzeichnet,**
**dass** der Asymmetriedetektor (AD) weiter umfasst:

einen Spitzenwert-Detektor (SD), der ausgebildet ist, einen Spitzenwert U_Peak der pulsierenden Gleichspannung UDC des Gleichrichters (BG) zu erfassen, wobei der Schwellwert ein Relativwert U_Rel = A x U_Peak in Form eines Anteils A des Spitzenwertes U_Peak ist, und wobei dann, wenn der Momentanwert UDC(t) unterbrechungsfrei über die Dauer der Einschaltverzögerungszeit dT_ev den Relativwert U_Rel nicht unterschreitet, d. h. die Augenblickswerte aller Phasenspannungen (UL1, UL2, UL3) unterbrechungsfrei über eine Einschaltverzögerungszeit dT_ev jeweils in etwa gleicher Größe detektiert werden, ein die Symmetrie anzeigendes Detektionssignal erzeugt wird und
wobei dann, wenn der Momentanwert UDC(t) einmalig den vorgegebenen Relativwert U_Rel unterschreitet, d. h. der Augenblickswert nur einer der Phasenspannungen (UL1, UL2, UL3) einen Sollwert unterschreitet, im Wesentlichen verzögerungsfrei ein die Asymmetrie anzeigendes Detektionssignal erzeugt wird.

**10.** Asymmetriedetektor (AD) zur Detektion einer Asymmetrie oder Symmetrie von Phasenspannungen (UL1, UL2, UL3) eines Mehrphasenstromnetzes (SN),

wobei der Asymmetriedetektor (AD) einen Gleichrichter (BG) umfasst, der ausgebildet ist, die Phasenspannungen (UL1, UL2, UL3) gleichzurichten,
wobei der Asymmetriedetektor (AD) einen Momentanwert-Detektor (MD) umfasst, der ausgebildet ist, einen Momentanwert MDC(t) der pulsierenden Gleichspannung UDC des Gleichrichters (BG) zu erfassen,
wobei der Asymmetriedetektor (AD) einen Komparator (K) umfasst, der ausgebildet ist, den Momentanwert UDC(t) mit einem Schwellwert zu vergleichen, wobei ein Ausgang (A1) des Komparators (K) mit einem Eingang einer Schalteinrichtung (SE) gekoppelt ist,
**dadurch gekennzeichnet,**
**dass** der Asymmetriedetektor (AD) weiter umfasst:

einen Spitzenwert-Detektor (SD), der ausgebildet ist, einen Spitzenwert U_Peak einer an einem Ausgang des Gleichrichters (BG) anliegende pulsierenden Gleichspannung UDC zu erfassen, wobei der Schwellwert ein Relativwert U_Rel = A x U_Peak in Form eines Anteils A des Spitzenwertes U_Peak,
und wobei erst dann, wenn der Momentanwert UDC(t) unterbrechungsfrei über die Dauer der Einschaltverzögerungszeit dT_ev den Relativwert U_Rel nicht unterschreitet, ein die Symmetrie anzeigendes De-tektionssignal erzeugt wird und

**EP 3 910 350 B1**

wobei dann, wenn der Momentanwert UDC(t) einmalig einen vorgegebenen Relativwert U_Rel unterschreitet, im Wesentlichen verzögerungsfrei ein die Asymmetrie anzeigendes Detektionssignal erzeugt wird.

11. Asymmetriedetektor nach Anspruch 9 oder 10,
**dadurch gekennzeichnet,**
**dass** ein Ausgang (AK) des Komparators (K) mit einem Eingang (ZE) eines Zeitgliedes (ZG) gekoppelt ist, dessen Ausgang (ZA) mit einem Eingang (ET) einer Triggerschaltung (ST) verbunden ist und dass an einem Ausgang (TA) der Triggerschaltung (ST) das Detektionssignal abgreifbar ist.

12. Asymmetriedetektor nach zumindest einem der Ansprüche 9 bis 11,
**dadurch gekennzeichnet,**
**dass** der Spitzenwert-Detektor (SD) eine Diode (D1) und einen Kondensator (C1) umfasst, die parallel zu dem Ausgang des Gleichrichters (BG) geschaltet sind, wobei parallel zu dem Kondensator (C1) ein Spannungsteiler aus Widerstand (R1, R2a, R2b) geschaltet ist und wobei eine Mittelanzapfung des Spannungsteilers mit dem invertierenden Eingang (E1) des Komparators (K) verbunden ist.

13. Asymmetriedetektor nach zumindest einem der Ansprüche 9 bis 12,
**dadurch gekennzeichnet,**
**dass** der Momentanwert-Detektor (MD) zur Erfassung des Momentanwertes UDC(t) der Ausgangsspannung UDC des Gleichrichters (BG) einen Spannungsteiler aus den Widerständen (R3, R4) aufweist, der parallel zu den Ausgängen UDC+, UDC- des Gleichrichters geschaltet ist, wobei eine Mittelanzapfung des Spannungsteilers aus den Widerständen (R3, R4) mit einem nicht invertierenden Eingang (E2) des Komparators (K) verbunden ist.

**Claims**

1. A method for detecting asymmetry or symmetry of phase voltages (UL1, UL2, UL3) of a multiphase power network (SN),

the instantaneous values of the phase voltages (UL1, UL2, UL3) being detected using an asymmetry detector (AD) by the asymmetry detector (AD) comprising a rectifier (BG) which is used to generate a pulsating DC voltage UDC by rectifying the phase voltages (UL1, UL2, UL3),
the asymmetry or symmetry of the phase voltages (UL1, UL2, UL3) being detected by analysing the pulsating DC voltage UDC, an instantaneous value UDC(t) of the pulsating DC voltage UDC being acquired using an instantaneous value detector (MD),
and the instantaneous value UDC(t) being compared with a threshold value using a comparator (K),
**characterised in that**
a peak value U Peak of the pulsating DC voltage UDC(t) is ascertained, and **in that** the threshold value is a relative value U_Re1 = A x U_Peak in the form of a fraction A of the peak value U_Peak,
wherein, when the instantaneous value UDC(t) does not fall below the relative value U_Re1 uninterruptedly over the duration of the switch-on delay time dT_ev, i.e. the instantaneous values of all the phase voltages (UL1, UL2, UL3) are in each case detected as being of approximately the same magnitude uninterruptedly over a switch-on delay time dT_ev, a detection signal indicating symmetry is generated, and
wherein, when the instantaneous value UDC(t) falls once below the specified relative value U_Rel, i.e. the instantaneous value of just one of the phase voltages (UL1, UL2, UL3) falls below a setpoint value, a detection signal DS indicating asymmetry is generated substantially without delay.

2. A method for detecting asymmetry or symmetry of phase voltages (UL1, UL2, UL3) of a multiphase power network (SN), the phase voltages (UL1, UL2, UL3) being detected using an asymmetry detector (AD) by the asymmetry detector (AD) comprising a rectifier (BG) which is used to generate a pulsating DC voltage UDC by rectifying the phase voltages (UL1, UL2, UL3),

the asymmetry or symmetry of the phase voltages being detected by analysing the pulsating DC voltage UDC, an instantaneous value UDC(t) of the pulsating DC voltage UDC being acquired using an instantaneous value detector, and the instantaneous value UDC(t) being compared with a threshold value using a comparator (K),
**characterised in that**
a peak value U_Peak of the pulsating DC voltage UDC is ascertained, and **in that** the threshold value is a relative value U_Rel = A x U_Peak in the form of a fraction A of the peak value U Peak,

wherein, when the instantaneous value UDC(t) falls once below a specified relative value U_Rel, the detection signal DS indicating asymmetry is generated and wherein the detection signal indicating symmetry is only generated again when the instantaneous value UDC(t) does not fall below the relative value U_Rel uninterruptedly over the duration of the switch-on delay time dT_ev.

3. A method according to Claim 1 or 2,
**characterised in that**
the switch-on delay time dT_ev is set by means of a timer (ZG) to a time in the range 600 ms $\leq$ dT_ev $\leq$ 1000 ms, preferably dT_ev = 800 ms.

4. A method according to Claim 1 or 2,
**characterised in that**
the fraction A lies in the range 0.75 $\leq$ A $\leq$ 0.8, and preferably amounts to A = 0.75.

5. A method according to at least one of the preceding claims,
**characterised in that**
the detection signal DS indicating asymmetry is generated in the event of failure of a phase voltage (UL1, UL2, UL3) or periodically in the event of undervoltage of a phase voltage (UL1, UL2, UL3) of, for example, 20 % relative to a setpoint voltage.

6. A method according to at least one of the preceding claims,
**characterised in that**
the detection signal DS indicating asymmetry is generated within a detection delay time dT_dv after onset of the asymmetry, wherein the detection delay time dT_dv lies in the range 0 ms $\leq$ dT_dv $\leq$ dT_dvmax, wherein the maximum detection delay time dT_dvmax is determined by the factor A and, when factor A is in the range 0.75 $\leq$ A $\leq$ 0.8, lies in the range 3 ms $\leq$ dT_dvmax $\leq$ 4 ms, with dT_dvmax preferably equalling 4 ms when factor A = 0.75.

7. A method according to at least one of the preceding claims,
**characterised in that**
to determine the peak value U_Peak, a capacitor (C1) is charged via a diode (D1) with the pulsating DC voltage UDC, and **in that** the relative value U_Rel is derived using a voltage divider (R1, R2a, R2b) from the peak value U_Peak applied to the capacitor (C1), wherein the voltage divider (R1, R2a, R2b) preferably has an adjustable divider ratio STV with which the relative value U_Rel is adjusted to the fraction A of the peak value U_Peak.

8. A method according to at least one of the preceding claims,
**characterised in that**
on discontinuation of the pulsating DC voltage UDC for an interval of time dT_p, with dT_p in the range from at least 50 ms to 500 ms, the comparator (K) is supplied with voltage by way of a buffered voltage supply.

9. An asymmetry detector (AD) for detecting asymmetry or symmetry of phase voltages (UL1, UL2, UL3) of a multiphase power network (SN),

the asymmetry detector (AD) comprising a rectifier (BG), which is configured to detect the instantaneous values of the phase voltages (UL1, UL2, UL3) and to rectify the phase voltages (UL1, UL2, UL3),
the asymmetry detector (AD) comprising an instantaneous value detector (MD), which is configured to acquire an instantaneous value MDC(t) of the pulsating DC voltage UDC of the rectifier (BG), and
the asymmetry detector (AD) comprising a comparator (K), which is configured to compare the instantaneous value UDC(t) with a threshold value, an output (A1) of the comparator (K) being coupled to an input of a switching device (SE), **characterised in that**
the asymmetry detector (AD) further comprises:

a peak value detector (SD), which is configured to acquire a peak value U_Peak of the pulsating DC voltage UDC of the rectifier (BG), wherein the threshold value is a relative value U_Re1 = A x U_Peak in the form of a fraction A of the peak value U_Peak, wherein, when the instantaneous value UDC(t) does not fall below the relative value U_Rel uninterruptedly over the duration of the switch-on delay time dT_ev, i.e. the instantaneous values of all the phase voltages (UL1, UL2, UL3) are in each case detected as being of approximately the same magnitude uninterruptedly over a switch-on delay time dT_ev, a detection signal indicating symmetry is generated, and

wherein, when the instantaneous value UDC(t) falls once below the specified relative value U_Rel, i.e. the instantaneous value of just one of the phase voltages (UL1, UL2, UL3) falls below a setpoint value, a detection signal indicating asymmetry is generated substantially without delay.

**10.** An asymmetry detector (AD) for detecting asymmetry or symmetry of phase voltages (UL1, UL2, UL3) of a multiphase power network (SN),

the asymmetry detector (AD) comprising a rectifier (BG), which is configured to rectify the phase voltages (UL1, UL2, UL3),

the asymmetry detector (AD) comprising an instantaneous value detector (MD), which is configured to acquire an instantaneous value MDC(t) of the pulsating DC voltage UDC of the rectifier (BG),

the asymmetry detector (AD) comprising a comparator (K), which is configured to compare the instantaneous value UDC(t) with a threshold value, an output (A1) of the comparator (K) being coupled to an input of a switching device (SE), **characterised in that**

the asymmetry detector (AD) further comprises:

a peak value detector (SD), which is configured to acquire a peak value U_Peak of a pulsating DC voltage UDC applied to an output of the rectifier (BG), wherein the threshold value is a relative value U_Rel = A x U_Peak in the form of a fraction A of the peak value U_Peak,

wherein, only when the instantaneous value UDC(t) does not fall below the relative value U_Rel uninterruptedly over the duration of the switch-on delay time dT_ev is a detection signal indicating symmetry generated, and

wherein, when the instantaneous value UDC(t) falls once below a specified relative value U_Rel, a detection signal indicating asymmetry is generated substantially without delay.

**11.** An asymmetry detector according to Claim 9 or 10,
**characterised in that**
an output (AK) of the comparator (K) is coupled to an input (ZE) of a timer (ZG), the output (ZA) of which is connected with an input (ET) of a trigger circuit (ST) and **in that** the detection signal can be picked off at an output (TA) of the trigger circuit (ST).

**12.** An asymmetry detector according to at least one of Claims 9 to 11,
**characterised in that**
the peak value detector (SD) comprises a diode (D1) and a capacitor (C1), which are connected in parallel to the output of the rectifier (BG), wherein a voltage divider consisting of resistors (R1, R2a, R2b) is connected in parallel to the capacitor (C1) and a centre tap of the voltage divider is connected to the inverting input (E1) of the comparator (K).

**13.** An asymmetry detector according to at least one of Claims 9 to 12,
**characterised in that**
the instantaneous value detector (MD) for acquiring the instantaneous value UDC(t) of the output voltage UDC of the rectifier (BG) has a voltage divider consisting of the resistors (R3, R4), which is connected in parallel to the outputs UDC+, UDC- of the rectifier, wherein a centre tap of the voltage divider consisting of the resistors (R3, R4) is connected with a non-inverting input (E2) of the comparator (K).

**Revendications**

**1.** Procédé destiné à la détection d'une asymétrie ou d'une symétrie de tensions de phase (UL1, UL2, UL3) d'un réseau électrique polyphasé (SN),

sachant que les valeurs instantanées des tensions de phase (UL1, UL2, UL3) sont détectées au moyen d'un détecteur d'asymétrie (AD), le détecteur d'asymétrie (AD) comprenant un redresseur (BG) au moyen duquel une tension continue pulsée UDC est générée par redressement des tensions de phase (UL1, UL2, UL3),

sachant que l'asymétrie ou la symétrie des tensions de phase (UL1, UL2, UL3) est détectée par l'analyse de la tension continue pulsée UDC, sachant qu'une valeur momentanée UDC(t) de la tension continue pulsée UDC est acquise au moyen d'un détecteur de valeur momentanée (MD),

et sachant que la valeur momentanée UDC(t) est comparée à une valeur seuil au moyen d'un comparateur (K),

**caractérisé en ce**

**qu'**une valeur de pointe U_Peak de la tension continue pulsée UDC(t) est déterminée, que 1a valeur seuil est une valeur relative U_Re1 = A x U_Peak sous la forme d'une fraction A de la valeur de pointe U_Peak, sachant que si la valeur momentanée UDC(t) ne descend pas en dessous de la valeur relative U_Rel sur la durée de temporisation d'activation dT_ev sans interruption, c.-à-d. si les valeurs instantanées de toutes le s tensions de phase (UL1, UL2, UL3) sont détectées respectivement de même taille environ sur une durée de temporisation d'activation dT_ev sans interruption, un signal de détection affichant la symétrie est généré et sachant que si la valeur momentanée UDC(t) descend une fois en dessous de la valeur relative prédéterminée U_Rel, c.-à-d. si la valeur instantanée d'une seule des tensions de phase (UL1, UL2, UL3) descend en dessous d'une valeur de consigne, essentiellement sans interruption, un signal de détection DS affichant l'asymétrie est généré.

2. Procédé destiné à la détection d'une asymétrie ou d'une symétrie de tensions de phase (UL1, UL2, UL3) d'un réseau électrique polyphasé (SN), sachant que les tensions de phase (UL1, UL2, UL3) sont détectées au moyen d'un détecteur d'asymétrie (AD), le détecteur d'asymétrie (AD) comprenant un redresseur (BG) au moyen duquel une tension continue pulsée UDC est générée par redressement des tensions de phase (UL1, UL2, UL3),

   sachant que l'asymétrie ou la symétrie des tensions de phase est détectée par l'analyse de la tension continue pulsée UDC, sachant qu'une valeur momentanée UDC(T) de la tension continue pulsée UDC est acquise au moyen d'un détecteur de valeur momentanée, et sachant que la valeur momentanée UDC(t) est comparée à une valeur seuil au moyen d'un comparateur (K),

   **caractérisé en ce**

   **qu'**une valeur de pointe U_Peak de la tension continue pulsée UDC est déterminée, que la valeur seuil est une valeur relative U_Rel = A x U_Peak sous la forme d'une fraction A de la valeur de pointe U_Peak, et sachant que si la valeur momentanée UDC(t) descend une fois en dessous d'une valeur relative prédéterminée U_Rel, le signal affichant l'asymétrie est généré et sachant que le signal de détection affichant la symétrie n'est généré à nouveau qu'une fois que la valeur momentanée UDC(t) ne descend pas en dessous de la valeur relative U_Rel pendant la durée de temporisation d'activation dT_ev, sans interruption.

3. Procédé selon la revendication 1 ou 2,
   **caractérisé en ce**
   **que** la durée de temporisation d'activation dT_ev est réglée au moyen d'un temporisateur (ZG) sur une durée telle que 600 ms ≤ dT_ev ≤ 1000 ms, de préférence dT_ev = 800 ms.

4. Procédé selon la revendication 1 ou 2,
   **caractérisé en ce**
   **que** la fraction A se situe sur la plage telle que 0,75 ≤ A ≤ 0,8, est de préférence A = 0,75.

5. Procédé selon au moins l'une des revendications précédentes,
   **caractérisé en ce**
   **que** le signal de détection DS affichant l'asymétrie est généré en cas de coupure d'une tension de phase (UL1, UL2, UL3) ou périodiquement en cas d'apparition d'une sous-tension d'une tension de phase (UL1, UL2, UL3) de 20 % par ex. par rapport à une tension de consigne.

6. Procédé selon au moins l'une des revendications précédentes,
   **caractérisé en ce**
   **que** le signal de détection DS affichant l'asymétrie est généré au cours d'une durée de temporisation de détection dT_dv après l'apparition de l'asymétrie, sachant que la durée de temporisation de détection dT_dv se situe sur la plage telle que 0 ms ≤ dT_dv ≤ dT_dvmax, sachant que la durée de temporisation de détection maximale dT_dvmax est déterminée par le facteur A et se situe, pour un facteur A dans la plage telle que 0,75 < A ≤ 0,8, dans la plage 3 ms ≤ dT_dvmax ≤ 4 ms et est de préférence dT_dvmax = 4 ms avec A = 0,75.

7. Procédé selon au moins l'une des revendications précédentes,
   **caractérisé en ce**
   **que** pour déterminer la valeur de pointe U_Peak, un condensateur (C1) est chargé avec la tension continue pulsée UDC via une diode (D1), que la valeur relative U_rel est dérivée de la valeur de pointe U_Peak présente sur le condensateur (C1) au moyen d'un diviseur de tension (R1, R2a, R2b), sachant que le diviseur de tension (R1, R2a, R2b) présente, de préférence, un rapport de division STV réglable avec lequel la valeur relative U_Rel est réglée sur la fraction A de la valeur de pointe U_Peak.

8. Procédé selon au moins l'une des revendications précédentes,
   **caractérisé en ce**
   **que** le comparateur (K) est alimenté en tension lors d'une coupure de la tension continue pulsée UDC pendant un laps de temps dT_p, avec dT_p dans la plage d'au moins 50 ms à 500 ms, au moyen d'une alimentation en tension tampon.

9. Détecteur d'asymétrie (AD) destiné à la détection d'une asymétrie ou d'une symétrie de tensions de phase (UL1, UL2, UL3) d'un réseau électrique polyphasé (SN),

   sachant que le détecteur d'asymétrie (AD) comprend un redresseur (BG) qui est conçu pour détecter les valeurs instantanées des tensions de phase (UL1, UL2, UL3) et redresser les tensions de phase (UL1, UL2, UL3),
   sachant que le détecteur d'asymétrie (AD) comprend un détecteur de valeur momentanée (MD) qui est conçu pour acquérir une valeur momentanée MDC(t) de la tension continue pulsée UDC du redresseur (BG), et
   sachant que le détecteur d'asymétrie (AD) comprend un comparateur (K) qui est conçu pour comparer la valeur momentanée UDC(t) à une valeur seuil, sachant qu'une sortie (A1) du comparateur (K) est couplée à une entrée d'un dispositif de commutation (SE),
   **caractérisé en ce**
   **que** le détecteur d'asymétrie (AD) comprend également :
   un détecteur de valeur de pointe (SD) qui est conçu pur acquérir une valeur de pointe U_Peak de la tension continue pulsée UDC du redresseur (BG), sachant que la valeur seuil est une valeur relative U_Rel = A x U Peak sous la forme d'une fraction A de la valeur de pointe U_Peak et sachant que si la valeur momentanée UDC(t) ne descend pas en dessous de la valeur relative U_Rel sur la durée de temporisation d'activation dT_ev sans interruption, c.-à-d. si les valeurs instantanées de toutes les tensions de phase (UL1, UL2, UL3) sont détectées respectivement de même taille environ sur une durée de temporisation d'activation dT_ev sans interruption, un signal de détection affichant la symétrie est généré et sachant que si la valeur momentanée UDC(t) descend une fois en dessous de la valeur relative prédéterminée U_Rel, c.-à-d. si la valeur instantanée d'une seule des tensions de phase (UL1, UL2, UL3) descend en dessous d'une valeur de consigne, essentiellement sans interruption, un signal de détection affichant l'asymétrie est généré.

10. Détecteur d'asymétrie (AD) destiné à la détection d'une asymétrie ou d'une symétrie de tensions de phase (UL1, UL2, UL3) d'un réseau électrique polyphasé (SN),

    sachant que le détecteur d'asymétrie (AD) comprend un redresseur (BG) qui est conçu pour redresser les tensions de phase (UL1, UL2, UL3),
    sachant que le détecteur d'asymétrie (AD) comprend un détecteur de valeur momentanée (MD) qui est conçu pour acquérir une valeur momentanée MDC(t) de la tension continue pulsée UDC du redresseur (BG),
    sachant que le détecteur d'asymétrie (AD) comprend un comparateur (K) qui est conçu pour comparer la valeur momentanée UDC(t) à une valeur seuil, sachant qu'une sortie (A1) du comparateur (K) est couplée à une entrée d'un dispositif de commutation (SE),
    **caractérisé en ce**
    **que** le détecteur d'asymétrie (AD) comprend également :

    un détecteur de valeur de pointe (SD) qui est conçu pour acquérir une valeur de pointe U_Peak d'une tension continue pulsée UDC présente sur une sortie du redresseur (BG), sachant que la valeur de seuil est une valeur relative U_Rel = A x U_Peak sous la forme d'une fraction A de la valeur de pointe U_Peak, et sachant qu'exclusivement dans le cas où la valeur momentanée UDC(t) ne descend pas en dessous de la valeur relative U_Rel sur la durée de temporisation d'activation dT_ev sans interruption, un signal de détection affichant la symétrie est généré et
    sachant que si la valeur momentanée UDC(t) descend une fois en dessous d'une valeur relative prédéterminée U_Rel, essentiellement sans temporisation, un signal de détection affichant l'asymétrie est généré.

11. Détecteur d'asymétrie selon la revendication 9 ou 10,
    **caractérisé en ce**
    **qu'**une sortie (AK) du comparateur (K) est couplée à une entrée (ZE) d'un temporisateur (ZG), dont la sortie (ZA) est reliée à une entrée (ET) d'un circuit de déclenchement (ST) et que le signal de détection est mesurable sur une sortie (TA) du circuit de déclenchement (ST).

**12.** Détecteur d'asymétrie selon au moins l'une des revendications 9 à 11,
**caractérisé en ce**
**que** le détecteur de valeur de pointe (SD) comprend une diode (D1) et un condensateur (C1) qui sont branchés parallèlement à la sortie du redresseur (BG), sachant qu'un diviseur de tension composé de résistances (R1, R2a, R2b) est branché parallèlement au condensateur (C1) et sachant qu'une prise centrale du diviseur de tension est reliée à l'entrée inverseuse (E1) du comparateur (K).

**13.** Détecteur d'asymétrie selon au moins l'une des revendications 9 à 12,
**caractérisé en ce**
**que** le détecteur de valeur momentanée (MD) destiné à acquérir la valeur momentanée UDC(t) de la tension de sortie UDC du redresseur (BG) présente un diviseur de tension composé des résistances (R3, R4) qui est branché parallèlement aux sorties UDC+, UDC- du redresseur, sachant qu'une prise centrale du diviseur de tension composé des résistances (R3, R4) est reliée à une entrée non inverseuse (E2) du comparateur (K).

Fig. 1

EP 3 910 350 B1

Fig. 2

**Fig. 3**

EP 3 910 350 B1

**Fig. 4**

EP 3 910 350 B1

**Fig. 5**

EP 3 910 350 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19509658 A1
- US 3843908 A
- US 20140233142 A1
- EP 1819021 A2